# EUROPEAN PATENT APPLICATION

(11) **EP 3 125 658 A1**
(43) Date of publication of application: **01.02.2017**
(21) Application number: 14887552.9
(22) Date of filing: 05.06.2014
(51) Int. Cl.: H05K 7/20

(54) **HEAT DISSIPATION APPARATUS FOR MOBILE COMMUNICATIONS DEVICE**

(30) Priority: 28.03.2014 CN 201420149397 U
(71) Applicant: ZTE Corporation, Shenzhen, Guangdong 518057 (CN)
(72) Inventor: YU, Turong, Shenzhen Guangdong 518057 (CN); ZONG, Baiqing, Shenzhen Guangdong 518057 (CN); XU, Dahe, Shenzhen Guangdong 518057 (CN)
(74) Representative: Regimbeau
(86) International application number: PCT/CN2014/079286
(87) International publication number: WO 2015/143782

(57) **Abstract**

The present invention provides a heat dissipation apparatus. The heat dissipation apparatus includes a chamber, and one of an air duct and an air duct half cavity. The chamber includes a chamber inlet configured to input an airflow and an escaping opening configured to output the input airflow from the chamber. The one of the air duct and the air duct half cavity is connected with the chamber through the escaping opening, and includes an air inlet and an air outlet, where air output from the escaping opening drives external air to flow towards the air outlet from the air inlet of the air duct. Therefore, compared with the traditional heat dissipation apparatus, the heat dissipation performance of the heat dissipation apparatus of the present invention can be greatly improved, and the heat dissipation reliability is good.

## Description

### TECHNICAL FIELD

The present invention relates to a heat dissipation apparatus, in particular to a heat dissipation apparatus for a communication device.

### BACKGROUND

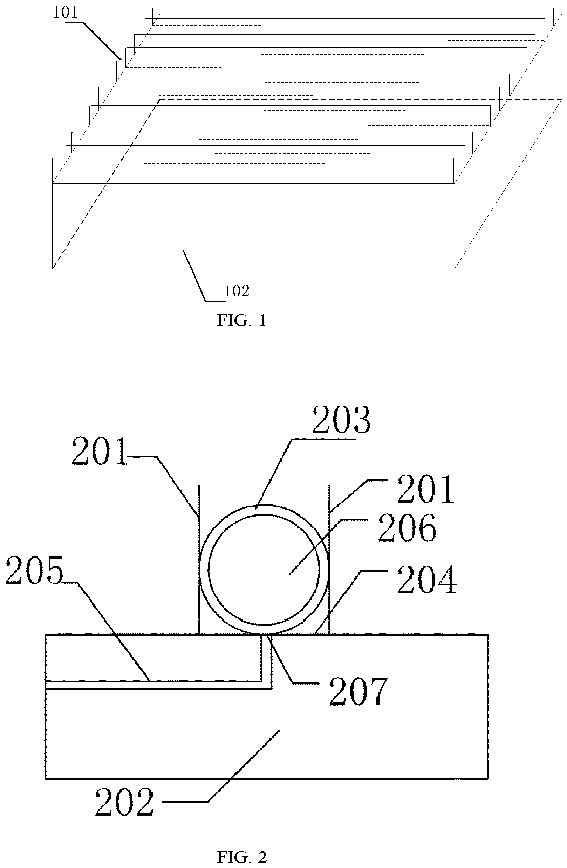

Heat dissipation within a system is critically important in various fields such as communication, Information Technology (IT), illumination, automobile manufacture and the like, thus it is necessary to perform a comprehensive simulation on the heat dissipation within the system at the phase of researching, developing and designing. Taking a mobile communication system as an example, miniaturization and high power of the device become a development trend of a distributed radio remote unit (RRU) in the field. However, the miniaturization cannot meet natural heat dissipation requirements required by high power. Fig. 1 illustrates a RRU in the existing art, on a shell 102 of which integrally designed and machined with heat sinks 101 with a natural heat dissipation function. A fan active heat dissipation technology is also proposed in the field, but has weaknesses such as poor reliability, high dust-proof requirement and the like, and may cause a noise problem.

### SUMMARY

In order to solve the problems in the existing art, improve the heat dissipation capacity of a system under a natural condition, and reduce the volume of a system device when attached with a heat dissipation apparatus,

Embodiments of the present invention provide a heat dissipation apparatus, including a chamber, and one of an air duct and an air duct half cavity; the chamber includes a chamber inlet configured to input an airflow and an escaping opening configured to output the input airflow from the chamber; and the one of the air duct and the air duct half cavity is connected with the chamber through the escaping opening, and includes an air inlet and an air outlet, where air output from the escaping opening drives external air to flow towards the air outlet from the air inlet of the air duct.

Preferably, the air duct half cavity is formed with heat sinks installed on a device being cooled and the surface of the device being cooled.

Preferably, the heat dissipation apparatus is installed at one end or in any position of the one of the air duct and the air duct half cavity.

Preferably, the one of the air duct and the air duct half cavity is made from a material easy to dissipate the heat, such as copper or aluminum alloy and the like.

In order to realize the embodiments of the present invention, the embodiments of the present invention further provide a device including a heat dissipation apparatus. The heat dissipation apparatus includes a chamber provided in a body and an air duct or an air duct half cavity; the chamber includes a chamber inlet configured to input an airflow and an escaping opening configured to output the input airflow from the chamber; the one of the air duct and the air duct half cavity is connected with the chamber through the escaping opening, and includes an air inlet and an air outlet, where air output from the escaping opening drives external air to flow towards the air outlet from the air inlet of the air duct; and the air duct is close to a surface to be cooled of the device, and the air duct half cavity is configured to be combined with the surface to be cooled to form the air duct.

Preferably, the air duct half cavity is formed with radiating fins installed on the device being cooled and the surface of the device being cooled.

Preferably, the heat dissipation apparatus is installed at one end or in any position of the one of the air duct and the air duct half cavity.

Preferably, the one of the air duct and the air duct half cavity is made from a material easy to dissipate the heat, such as copper or aluminum alloy and the like.

Compared with the existing art, the present application improves the heat dissipation capacity of the system under a natural condition, reduces the volume of the system device when attached with the heat dissipation device, and solves the reliability problem of the heat dissipation device.

### BRIEF DESCRIPTION OF DRAWINGS

The drawings are used to further understand technical solutions of the present invention and constitute a portion of the description; and the drawings are used to illustrate the technical solutions of the present invention together with embodiments of the present application but not to limit the technical solutions of the present invention.
Fig. 1 illustrates a heat dissipation apparatus for a radio remote unit (RRU) in the existing art;
Fig. 2 is a front view showing a single heat dissipation apparatus being installed on an apparatus being cooled;
Fig. 3 is a side section view showing a single heat dissipation apparatus being installed on a device being cooled;
Fig. 4 illustrates an embodiment of a plurality of heat dissipation apparatuses being installed on a same surface of an apparatus being cooled; and
Fig. 5 illustrates an embodiment of one air source being shared by a plurality of apparatuses being cooled.

### DETAILED DESCRIPTION

In order to make the technical solutions and advantages of embodiments of the present invention more clear and apparent, the technical solutions provided in the present invention are further described in detail with reference to the drawings and specific embodiments, so that those skilled in the art can better understand and implement the present invention, but the illustrated embodiments are not used to limit the present invention. It should be stated that in the case of non-conflict, the embodiments in the present application and features in the embodiments can be mutually combined.

Fig. 2 is a front view showing a single heat dissipation apparatus, i.e., a front view in which the heat dissipation apparatus is installed on an apparatus being cooled. A chamber is labelled with 203, an air duct half cavity is formed with heat sinks 201 installed at two sides of the chamber and a surface of an apparatus being cooled 204, i.e. the air duct half cavity is an air duct with three sides closed and two ends open.

Preferably, the air duct may be a tubular air duct with four sides closed and two ends open, therefore, compared with an air duct with half-cavity, the airflow flowing through the heat dissipation apparatus may flow through the whole air duct, thereby achieving a better heat dissipation effect.

The chamber 203 includes a chamber inlet configured to input an airflow and an escaping opening for outputting the input airflow from the chamber; an air source inputs air to the chamber 203 through the chamber inlet 207, via an air supply pipe 205; after the chamber 203 being fully filled with the air, the air can be output from the escaping opening of the chamber and enters the air duct or the air duct half cavity to drive the external air to flow towards the air outlet from the air inlet 206 of the air duct, thereby achieving a heat dissipation effect.

Preferably, the escaping opening for outputting from the chamber may be provided with a guide plate for guiding the airflow discharged from the chamber to flow towards the air outlet, thereby better driving the external air to enter from the air inlet 206 and to discharge from the air outlet so as to enter the air duct or the air duct half cavity, thereby achieving a heat dissipation effect.

Preferably, the chamber may be installed at one end or in a middle position of the air duct or the air duct half cavity, or may be installed in any position of the air duct as needed, and installed in any position means being installed at a desired interface position as needed.

In order to enable the heat dissipation apparatus to have a better heat dissipation effect, a material easy to dissipate the heat may be adopted to form the air duct, for example, conventional heat sinks made from copper base-material, heat sinks made from aluminum alloy material, heat sinks made from cast-iron and the like are adopted to form the air duct.

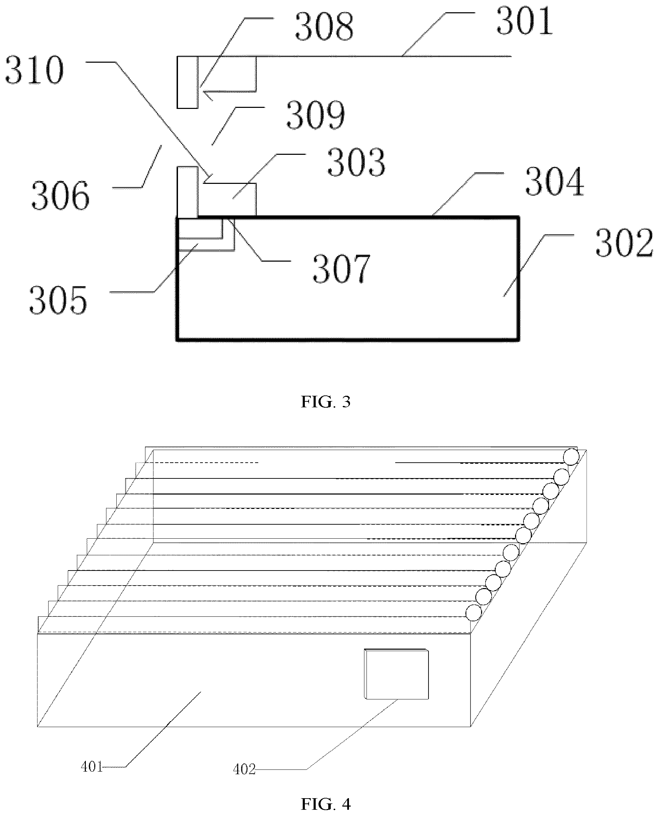

The embodiments of the present invention further provide a device, and Fig. 3 is a side section view showing a heat dissipation apparatus being installed on an apparatus being cooled. The device includes a heat dissipation apparatus and an apparatus 302 being cooled, wherein the heat dissipation apparatus includes a chamber 303 provided in a body and an air duct or an air duct half cavity; the chamber 303 includes a chamber inlet 307 configured to input an airflow and an escaping opening 308 for outputting the input airflow from the chamber; and the air duct or the air duct half cavity is connected with the chamber 303 through the escaping opening 308, and includes an air inlet 306 and an air outlet 309, wherein air output from the escaping opening 308 drives external air to flow towards the air outlet 309 from the air inlet 306 of the air duct; and the air duct is close to a surface to be cooled of the device, and the air duct half cavity is configured to be combined with the surface to be cooled to form the air duct.

Preferably, the air duct half cavity is formed with heat sinks 301 installed on the device being cooled and a surface of the device being cooled 304. The air duct half cavity may be formed in a way of independently installing the heat sinks on the surface of the device, or may be formed in a way of integrally machining the heat sinks with the device being cooled.

Preferably, the escaping opening of the chamber may be provided with a guide plate 310 for guiding the airflow from the chamber to flow towards the air outlet, thereby better driving the external air to enter from the air inlet and to discharge from the air outlet to enter the air duct or the air duct half cavity, and achieving a heat dissipation effect.

Preferably, the air duct may be a tubular air duct with four sides closed and two ends open, therefore, compared with an air duct with half-cavity, the airflow flowing through the heat dissipation device may flow through the whole air duct, thereby achieving a better heat dissipation effect.

Preferably, the chamber may be installed at one end or in a middle position of the air duct or the air duct half cavity, or may be installed in any position of the air duct as needed, and installed in any position means being installed at a desired sectional position as needed. As shown in Fig. 3, the chamber is installed at one end of the air duct.

In order to enable the heat dissipation apparatus to have a better heat dissipation effect, a material easy to dissipate the heat may be adopted to form the air duct or the air duct half cavity, for example, conventional heat sinks made from copper base-material, heat sinks made from aluminum alloy material, heat sinks made from cast-iron are adopted to form the air duct or the air duct half cavity.

As shown in Fig. 4, when a volume of an apparatus 401 being cooled is large, a plurality of heat dissipation apparatuses can be installed side by side on the surface of the apparatus being cooled, thereby improving the heat dissipation effect. An air source 402 may be installed on the apparatus being cooled, and air is input to the chambers of various heat dissipation apparatuses through an air supply passage.

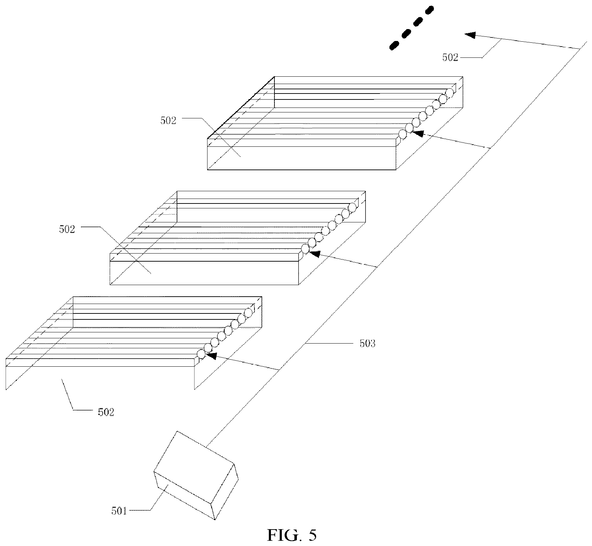

As shown in Fig. 5, on the premise of having a plurality of apparatuses 502 being cooled, the plurality of apparatuses being cooled may share one air supply apparatus 501, i.e. share one air source. After the air being delivered to each single apparatus being cooled 502 through the air supply passage 503 by the shared air supply apparatus 501, the air is separately delivered by the air supply passage of the single apparatus being cooled to the chamber of each heat dissipation apparatus so as to dissipate the heat.

Although the above discloses the embodiments of the present invention, the contents described above are merely embodiments for facilitating the understanding of the present invention, rather than limiting the present invention. Any modifications and changes can be made to the implementation form and details by those skilled in the art on the premise of not departing from the spirit and scope of the disclosure of the present invention; however, the patent protection scope of the present invention should still refer to the scope defined by the appended claims.

### INDUSTRIAL APPLICABILITY

The heat dissipation apparatus provided in the present invention has the following beneficial effects: improving the heat dissipation capacity of a system under a natural condition while reducing the volume problem of system device when attached with the heat dissipation apparatus, and solving the reliability problem of the heat dissipation device.

## Claims

1. A heat dissipation apparatus, comprising:
a chamber, and one of an air duct and an air duct half cavity;
wherein the chamber comprises a chamber inlet configured to input an airflow and an escaping opening configured to output the input airflow from the chamber; and
the one of the air duct and the air duct half cavity is connected with the chamber through the escaping opening, and comprises an air inlet and an air outlet, wherein air output from the escaping opening drives external air to flow towards the air outlet from the air inlet of the air duct.

2. The heat dissipation apparatus of claim 1, wherein the air duct half cavity is formed with heat sinks installed on a device being cooled and a surface of the device being cooled.

3. The heat dissipation apparatus of claim 1, wherein the heat dissipation apparatus is installed at one end or in any position of the one of the air duct and the air duct half cavity.

4. The heat dissipation apparatus of claim 1, wherein one of the air duct and the air duct half cavity is made from a material easy to dissipate the heat, such as copper or aluminum alloy and the like.

5. A device, comprising a heat dissipation apparatus which comprises a chamber provided in a body and one of an air duct and an air duct half cavity;
the chamber comprises a chamber inlet configured to input an airflow and an escaping opening configured to output the input airflow from the chamber;
the one of the air duct and the air duct half cavity is connected with the chamber through the escaping opening, and comprises an air inlet and an air outlet, wherein air output from the escaping opening drives external air to flow towards the air outlet from the air inlet of the air duct; and
the air duct is close to a surface to be cooled of the device, and the air duct half cavity is configured to be combined with the surface to be cooled to form the air duct.

6. The device of claim 5, wherein the air duct half cavity is formed with heat sinks installed on a device being cooled and a surface of the device being cooled.

7. The device of claim 5, wherein the heat dissipation apparatus is installed at one end or in any position of the one of the air duct and the air duct half cavity.

8. The device of claim 5, wherein the one of the air duct and the air duct half cavity is made from a material easy to dissipate the heat, such as copper or aluminum alloy and the like.
